**Europäisches Patentamt**

**European Patent Office**

**Office européen des brevets**

(19)

(11) Veröffentlichungsnummer: **0 124 765**
**B1**

(12) # EUROPÄISCHE PATENTSCHRIFT

(45) Veröffentlichungstag der Patentschrift:
02.09.87

(21) Anmeldenummer: **84103697.3**

(22) Anmeldetag: **04.04.84**

(51) Int. Cl.⁴: **H 03 F 3/217,** H 03 M 1/80

(54) **Schaltverstärker zur digitalen Leistungsverstärkung.**

(30) Priorität: **10.05.83 CH 2546/83**

(43) Veröffentlichungstag der Anmeldung:
**14.11.84 Patentblatt 84/46**

(45) Bekanntmachung des Hinweises auf die Patenterteilung:
**02.09.87 Patentblatt 87/36**

(84) Benannte Vertragsstaaten:
**CH DE FR GB LI NL**

(56) Entgegenhaltungen:
**EP-A-0 058 443**
**EP-A-0 066 904**
**FR-A-2 340 644**
**FR-A-2 404 337**

(73) Patentinhaber: **BBC Aktiengesellschaft Brown, Boveri & Cie., Haselstrasse, CH- 5401 Baden (CH)**

(72) Erfinder: **Furrer, Andreas, Dipl.- Phys., Im Feld, CH- 5237 Mönthal (CH)**

EP 0 124 765 B1

**Beschreibung**

Die Erfindung betrifft einen Schaltverstärker zur digitalen Leistungsverstärkung eines analogen Eingangssignals gemäss dem Oberbegriff des Anspruchs 1.

Ein solcher Verstärker, bei dem der gesamte mögliche Spannungsbereich des analogen Eingangssignals in eine Mehrzahl von gleichen Spannungsstufen unterteilt und jeder Spannungsstufe eine Schaltstufe zugeordnet werden, und bei dem jeweils gerade soviele Schaltstufen mit ihren Ausgangsspannungen in Serie geschaltet und summiert werden, wie der Anzahl der Spannungsstufen innerhalb der jeweiligen Amplitude des analogen Eingangssignals entsprechen, ist beispielsweise aus der DE-A1- 30 44 956 bekannt. Als Ausgangssignal entsteht bei diesem Verfahren eine zeitabhängige Spannung in Form eines Treppenzuges, die nach einer Glättung in einem Tiefpassfilter das entsprechend verstärkte, analoge Eingangssignal approximiert.

Der beschriebene Verstärker hat sich insbesondere bereits als Modulationsverstärker in Leistungssendern bewährt und zu einer wesentlichen Verbesserung des Sender-Wirkungsgrades im Bezug auf die eingesetzte elektrische Energie beigetragen.

Ein wesentliches Merkmal des bekannten Verstärkers ist die feste Zuordnung zwischen den Spannungstufen des Eingangssignalbereiches und den entsprechenden Schaltstufen auf der Ausgangsseite. Jedesmal, wenn die Amplitude des Eingangssignals beim Zunehmen eine bestimmte Spannungsstufe erreicht, wird eine bestimmte, zu dieser Spannungsstufe gehörende Schaltstufe in die Serienschaltung zugeschaltet, d.h. deren Ausgangsspannung in die ausgangsseitige Summation mit aufgenommen. Jedesmal, wenn die Amplitude des Eingangssignals andererseits beim Abnehmen diese bestimmte Spannungsstufe unterschreitet, wird die dieselbe Schaltstufe aus der Serienschaltung weggeschaltet, so dass ihre Ausgangsspannung zur Summation nicht länger beiträgt. Liegt dagegen die Amplitude ständig unterhalb bzw. oberhalb dieser Spannungsstufe, so bleibt die zugehörige Schaltstufe ständig weg- bzw. zugeschaltet.

Da im normalen Verstärkungsbetrieb, wie er beispielsweise in einem Rundfunksender vorliegt, aufgrund einer statistischen Verteilung sehr kleine aber auch sehr grosse Signalamplituden bei dem analogen Eingangssignal vergleichsweise weniger häufig auftreten als mittlere Amplituden, finden in den jenen Amplitudenbereichen zugeordneten Schaltstufen vergleichsweise weniger häufig Schaltvorgänge statt: Die für kleine Amplituden zuständigen Schaltstufen sind in der überwiegenden Zeit zugeschaltet, die für hohe Amplituden zuständigen Schaltstufen entsprechend in der überwiegenden Zeit ausgeschaltet. In Übereinstimmung mit der ungleichen Amplitudenverteilung gibt es daher aufgrund der starren Zuordnung bei dem bekannten Verstärker für die verschiedenen Schaltstufen auch ungleiche Betriebsbedingungen.

Zu dieser ungleichen Verteilung der Schaltvorgänge kommt eine weitere, sehr gravierende Ungleichheit in den Belastungen der Schaltstufen, die aus dem Prinzip der Serienschaltung resultiert: Je mehr Schaltstufen bei gleichbleibender Last am Ausgang in Serie geschaltet sind, desto höher ist die Spannungssumme der in Serie liegenden Ausgangsspannungen und damit auch der durch jede Schaltstufe fliessende Strom. Wird daher bei einer bereits vorhandenen Serienschaltung von vielen Schaltstufen eine Schaltstufe zu- oder weggeschaltet, muss innerhalb dieser Stufe ein wesentlich höherer Strom geschaltet werden als in denjenigen Stufen, die am Anfang einer Serienschaltung stehen. Demnach ist die Strombelastung der Schaltelemente in den Schaltstufen umso grösser, je höher die Eingangssignalamplitude der ihnen zugeordneten Spannungsstufen ist, so dass, vereinfacht, bei der festen Zuordnung nach dem Stand der Technik die oberen Schaltstufen stets einer hohen Schaltbelastung unterliegen, während die unteren Schaltstufen eine geringe Schaltbelastung tragen.

Schliesslich kommt es bei dem bekannten Verstärker unter bestimmten Voraussetzungen zu sehr kurzen Zu- bzw. Wegschaltperioden für die einzelnen Schaltstufen, die eine unnötig hohe Schaltfrequenz für die in den Schaltstufen verwendeten Schaltelemente erforderlich machen, so dass beispielsweise Thyristoren wegen der intern und durch die externen Beschaltungselemente verursachten Verzögerungsvorgänge nur beschränkt eingesetzt werden können. Wird nämlich z. B. ein höherfrequentes Eingangssignal, dessen Amplitude nur zwischen zwei benachbarten Spannungsstufen variiert, verstärkt, werden die zugehörigen Schaltstufen mit derselben höheren Frequenz zu- und weggeschaltet, während andere Schaltstufen unverändert zu- bzw. weggeschaltet bleiben.

Aufgabe der vorliegenden Erfindung ist es daher, einen Schaltverstärker zur digitalen Leistungsverstärkung eines analogen Eingangssignals zu schaffen, der einen gleichmässigeren Betrieb der einzelnen Schaltstufen gewährleistet und zudem eine Reduktion der erforderlichen Schaltfrequenzen in den Schaltstufen ermöglicht.

Die Aufgabe wird bei einem Verstärker der eingangs genannten Art durch die Merkmale aus dem kennzeichnenden Teil des Anspruchs 1 gelöst.

Durch die Neufestlegung der Zuordnung zwischen Spannungsstufen und Schaltstufen vor jedem Schaltvorgang ergibt sich der entscheidende Vorteil, dass die Schaltstufen unabhängig von der Art des analogen Eingangssignals und dessen Amplitudenverteilung gleichmässiger betrieben werden können.

Besonders günstig ist es, den Betriebszustand der Schaltstufen fortlaufend zu überwachen und die Zuordnung zwischen Spannungsstufe und Schaltstufe vor jedem Schaltvorgang nach Massgabe des jeweiligen Betriebszustandes festzulegen, weil so eine Rückkopplung zwischen dem Betriebszustand und der Schaltstufensteuerung möglich ist, die auf jede Schaltstufe individuell reagiert.

In einer weiteren, bevorzugten Ausführungsform des erfindungsgemässen Verstärkers wird die Zeit zwischen zwei aufeinanderfolgenden Schaltvorgängen für jede Schaltstufe gemessen und für den jeweiligen Schaltvorgang des Zu- bzw. Wegschaltens einer Schaltstufe diejenige Schaltstufe ausgewählt, die seit ihrem letzten Schaltvorgang die längste Zeit weg- bzw. zugeschaltet gewesen ist. Auf diese Weise können insbesondere die sehr kurzen Schaltperioden in den Schaltstufen vermieden werden.

Nachfolgend soll nun anhand der Zeichnung die Erfindung beschrieben und in Ausführungsbeispielen näher erläutert werden.

Es zeigen:.

Fig. 1 das Blockschaltbild einer Ausführungsform des Schaltverstärkers nach der Erfindung mit zusätzlicher Überwachungseinheit;

Fig. 2 ein Ausführungsbeispiel für eine Überwachungseinheit aus Fig. 1;

Fig. 3 ein Ausführungsbeispiel für eine Ansteuereinheit aus Fig. 1;

Fig. 4 ein Ausführungsbeispiel für einen Signalwandler aus Fig. 1;

Fig. 5a-e die Zuordnung zwischen den Spannungs- und Schaltstufen bei einem Ausführungsbeispiel der Erfindung für zwei verschiedene Eingangssignalamplituden im Vergleich zum Stand der Technik.

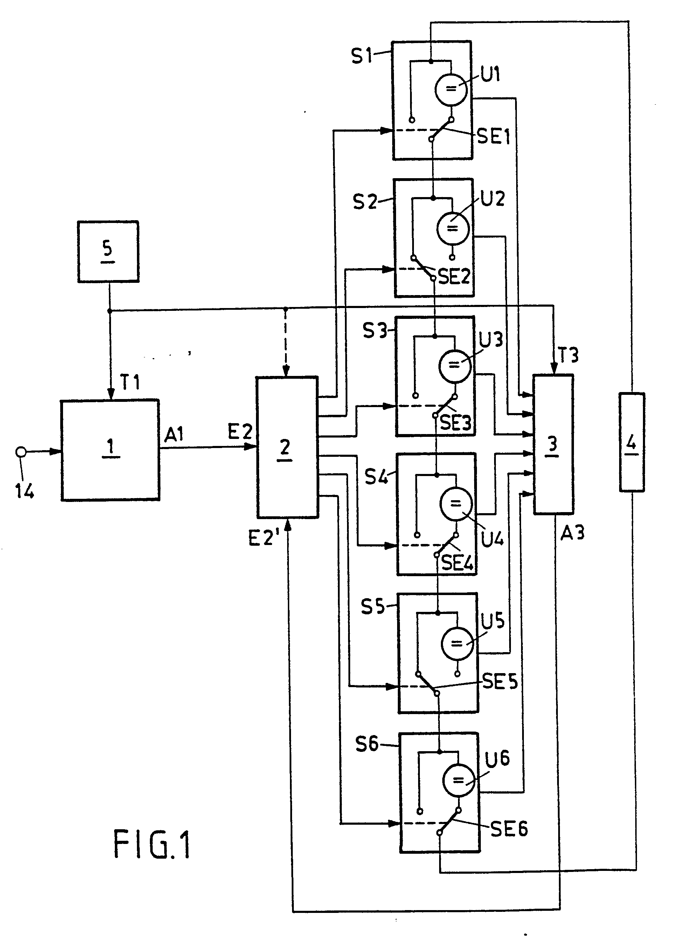

In Fig. 1 ist das Blockschaltbild einer Ausführungsform des Schaltverstärkers nach der Erfindung mit zusätzlicher Überwachungseinheit dargestellt. Von einem Eingang 14 gelangt das zu verstärkende, analoge Eingangssignal auf einen Signalwandler 1. Der Signalwandler 1 gibt an einem Ausgang A1 Steuerbefehle ab, die über einen Eingang E2 in eine Ansteuereinheit 2 eingespeist werden. Von der Ansteuereinheit 2 gehen Steuerleitungen zu einer Mehrzahl von Schaltstufen S1... S6, von denen im vorliegenden Beispiel der Übersichtlichkeit wegen nur sechs vorhanden sind. Die Schaltstufen S1... S6 enthalten leistungsfähige Gleichspannungsquellen U1... U6 mit im wesentlichen gleicher Ausgangsspannung und entsprechende Schaltelemente SE1... SE6, die beispielsweise als Umschalter ausgebildet und zusammen mit den Gleichspannungsquellen U1... U6 so angeordnet sind, dass die Quellen mit ihrer Ausgangsspannung wahlweise in Serie geschaltet werden können.

Von jeder der Schaltstufen S1... S6 führt in diesem Fall eine Überwachungsleitung zu einer gemeinsamen Überwachungseinheit 3, in der bestimmte Betriebsparameter von den Schaltstufen S1... S6 überwacht werden. Von der Überwachungseinheit 3 werden über einen Ausgang A3 Steuer- und Adressbefehle abgegeben, die durch einen Eingang E2' zurück in die Ansteuereinheit 2 gelangen, so dass eine Rückkopplungsschleife entsteht. Die Schaltstufen S1... S6 arbeiten in ihrer Serienschaltung auf eine Last 4, die beispielsweise als HF-Endstufe eines Rundfunksenders ausgebildet sein und zusätzlich ein Tiefpassfilter zur Glättung aufweisen kann. Der zeitliche Ablauf der Vorgänge im Schaltverstärker wird zwischen den einzelnen Funktionseinheiten zweckmässigerweise durch einen gemeinsamen Taktgeber 5 gesteuert und synchronisiert, der über entsprechende Taktleitungen zumindest mit dem Signalwandler 1 und der Überwachungseinheit 3, bei Bedarf auch mit der Ansteuereinheit 2 verbunden ist.

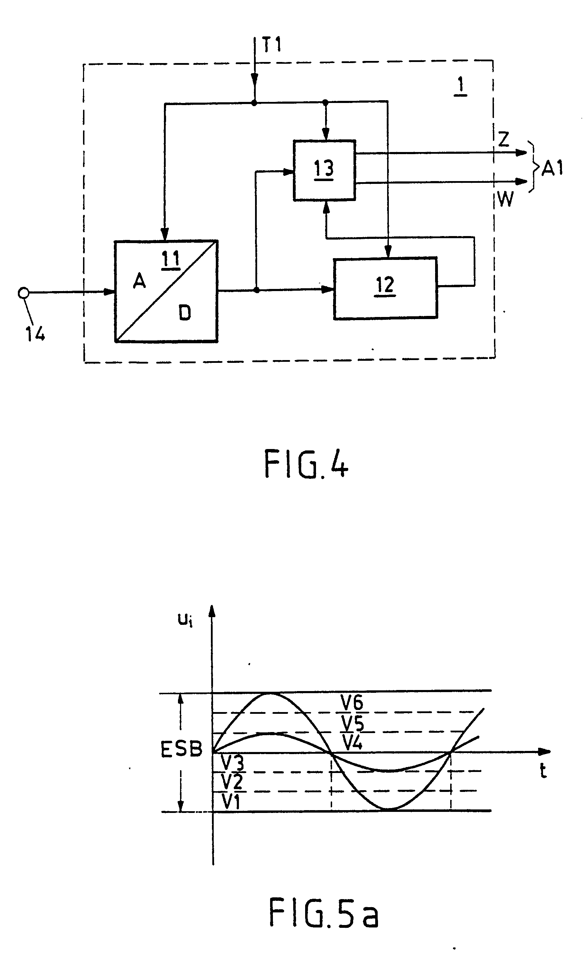

Der Signalwandler 1 teilt, wie in Fig. 5a angedeutet, den Eingangssignalbereich ESB, d.h. den Bereich maximaler Signalamplitude $u_i$, in eine Mehrzahl von gleichen Spannungsstufen V1... V6 auf. Er tastet periodisch mit der Taktfrequenz des Taktgebers 5 die momentane Amplitude des analogen Eingangssignals ab und stellt fest, wie viele Spannungsstufen in dem abgetasteten Amplitudenwert jeweils enthalten sind. Hat sich die Zahl dieser Spannungsstufen gegenüber dem beim vorangegangen Abtastvorgang ermittelten Wert um Eins erhöht, wird am Ausgang A1 ein entsprechender Steuerbefehl abgegeben, der zum Zuschalten einer zusätzlichen Schaltstufe in die Serienschaltung führt. Hat sich die Zahl dagegen um Eins erniedrigt, wird in analoger Weise ein Steuerbefehl abgegeben, der zum Wegschalten einer der Schaltstufen S1... S6 aus der Serienschaltung führt. Welche der Schaltstufen S1... S6 zu- bzw. weggeschaltet wird, richtet sich nach den Steuer- und Adressbefehlen aus der Überwachungseinheit 3.

Ein Ausführungsbeispiel für den Signalwandler 1 aus Fig. 1 ist in Fig. 4 dargestellt. Das analoge Eingangssignal erreicht über den Eingang 14 einen Analog-Digital (A/D)-Wandler 11, der durch einen Takteingang T1 vom Taktsignal des Taktgebers 5 gesteuert wird und beispielsweise alle 10 µsec das Eingangssignal abtastet. Der A/D-Wandler 11 erzeugt einen der Signalamplitude entsprechenden digitalen Wert, der in einen Amplitudenwertspeicher 12 eingespeichert wird. Gleichzeitig mit der Einspeicherung im Amplitudenwertspeicher 12 gelangt der Wert auf den Eingang einer Vergleichslogik 13, die ebenfalls über den Takteingang T1 getaktet wird. Auf einen anderen Eingang der Vergleichslogik 13 wird derjenige digitale Amplitudenwert gegeben, der aus dem vorangegangenen Abtastvorgang stammt und vor dem Einspeichern des neuen Wertes im Amplitudenwertspeicher 12 abgespeichert war und simultan zum Einlesen des neuen Wertes ausgespeichert wird.

Auf diese Weise wird in der Vergleichslogik 13 der gerade abgetastete Amplitudenwert mit dem jeweils zuvor abgetasteten Wert in Form der äquivalenten, digitalen Werte verglichen. Bei einer Amplitudenerhöhung gibt die Vergleichslogik 13 einen Steuerbefehl über eine Zuschaltleitung Z, bei Amplitudenerniedrigung einen Steuerbefehl über eine Wegschaltleitung W ab, die beide den Ausgang A1 bilden.

Weiterhin ist es aber auch möglich, als Vergleichswert für die Vergleichslogik 13 nicht den aus dem vorangegangenen Abtastvorgang stammenden, digitalen Amplitudenwert aus dem A/D-Wandler 11 zu nehmen, sondern denjenigen Digitalwert, welcher der Anzahl der tatsächlich eingeschalteten Schaltstufen entspricht. Dadurch lässt sich vermeiden, dass etwaige Steuerungsfehler zwischen dem Signalwandler 1 und den Schaltstufen S1... S6 unkorrigiert den Verlauf des Signals am Ausgang des Schaltverstärkers verfälschen.

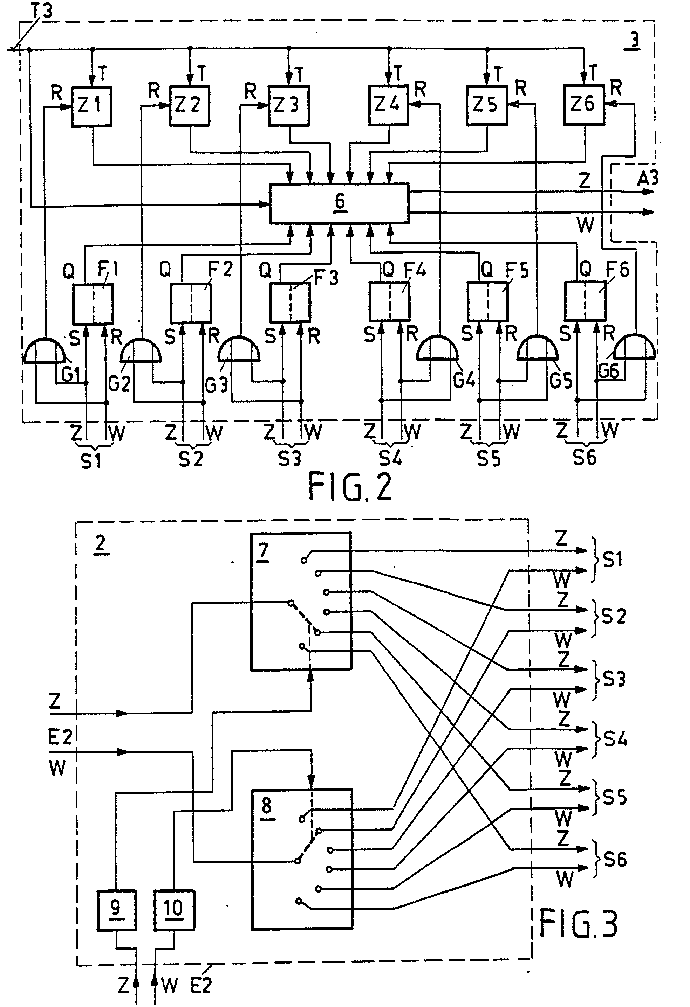

Die Leitungen Z und W führen zum entsprechenden Eingang E2 der Ansteuereinheit 2, deren Aufbau in einem Ausführungsbeispiel in Fig. 3 wiedergegeben ist. Die Zuschaltleitung Z endet innerhalb der Ansteuereinheit 2 in einer Umschaltlogik 7, die Wegschaltleitung W in einer gleichartigen Umschaltlogik 8. Die beiden Umschaltlogiken 7 und 8 werden durch zugeordnete Dekodierer 9 und 10 angesteuert, die über den Eingang E2' von der Überwachungseinheit 3 eine Adressinformation in codierter Form über diejenigen beiden Schaltstufen erhalten, die als nächste Stufen zu- bzw. weggeschaltet werden sollen. Sobald die ankommende Adressinformation in dem angesteuerten Dekodierer 9 oder 10 dekodiert worden ist, aktiviert dieser Dekodierer die zugehörige Ansteuerlogik 7 oder 8, die dann eine Verbindung zwischen der eingangsseitigen Zu- oder Wegschaltleitung Z oder W und derjenigen ausgangsseitigen Zu- oder Wegschaltleitung herstellt, die zu der Schaltstufe führt, der die verarbeitete Adressinformation zugeordnet ist.

Insgesamt ist jede Schaltstufe S1... S6 mit der Ansteuereinheit 2 über ein Leitungspaar aus einer Zuschaltleitung Z und einer Wegschaltleitung W verbunden, über die entweder ein Steuerbefehl zum Zuschalten oder aber ein Steuerbefehl zum Wegschalten an die Schaltstufe gegeben werden kann. Ist beispielsweise die Schaltstufe S5 noch nicht zugeschaltet und die Umschaltlogik 7 gerade so eingestellt, dass der nächste Zuschaltbefehl zu dieser Schaltstufe S5 gelangt, wird diese Schaltstufe mit ihrer Gleichspannungsquelle U5 in die Serienschaltung einbezogen und die Ausgangsspannung um den entsprechenden Wert erhöht. In der Überwachungseinheit 3 wird nun anhand der Betriebsdaten aller Schaltstufen eine neue, noch nicht zugeschaltete Schaltstufe ausgewählt und die zugehörige Adressinformation über den Dekodierer 9 an die Umschaltlogik 7 übermittelt, die eine mit der Adressinformation korrespondierende, neue Zuordnung zwischen ihrem Ein- und Ausgang herstellt, so dass beim Eintreffen des nächsten Zuschaltbefehls aus dem Signalwandler 1 die neu ausgewählte Schaltstufe zugeschaltet wird. Ein analoger Ablauf ergibt sich beim Wegschalten mit Hilfe des Dekodierers 10 in der Umschaltlogik 8.

Der interne Aufbau der Überwachungseinheit 3 richtet sich im einzelnen danach, auf welche Weise der Betriebszustand der Schaltstufen S1... S6 überwacht werden soll. Gemäss einem bevorzugten Ausführungsbeispiel des erfindungsgemässen Verfahrens wird die Zeit zwischen zwei aufeinanderfolgenden Schaltvorgängen für jede Schaltstufe gemessen und für den jeweiligen Vorgang des Zu- bzw. Wegschaltens diejenige Schaltstufe ausgewählt, die seit ihrem letzten Schaltvorgang die längste Zeit weg- bzw. zugeschaltet gewesen ist. Eine für diese Art der Überwachung geeignete Schaltung für die Überwachungseinheit 3 ist in Fig. 2 dargestellt.

Von den Schaltstufen S1... S6 führen Paare von Überwachungsleitungen zu der Überwachungseinheit 3, von denen jedes Paar wiederum eine Zuschaltleitung Z und eine Wegschaltleitung W umfasst. Jedes Paar von Überwachungsleitungen ist mit dem Setzeingang S bzw. Rücksetzeingang R eines Speichers F1... F6 verbunden, der als bistabile Kippschaltung (Flip-Flop) ausgeführt ist. Die Ausgänge Q der Speicher F1... F6 sind über Leitungen mit einer entsprechenden Anzahl von Eingängen an einer Vergleichslogik 6 verknüpft. Jedes Paar von Überwachungsleitungen ist weiterhin über ODER-Gatter G1... G6 mit den Rücksetzeingängen R einer Reihe von Zählern Z1... Z6 verbunen, von denen jeder einer der Schaltstufen S1... S6 zugeordnet ist. Die Zähler Z1... Z6 zählen die Taktimpulse aus dem Taktgeber 5, die über den Takteingang T3 auf die einzelnen Takteingänge T der Zähler Z1... Z6 gelangen. Der jeweilige Zählerstand der Zähler Z1... Z6 wird über Leitungen an die Vergleichslogik 6 weitergegeben und dort ausgewertet.

Die Funktionsweise der beschriebenen Überwachungseinheit 3 ist die folgende: Jedesmal, wenn eine der Schaltstufen S1... S6 durch einen Steuerbefehl aus dem Signalwandler 1 beispielsweise über die Umschaltlogik 7 zugeschaltet wird, gelangt ein Impuls über die Zuschaltleitung Z des zugehörigen Paars von Überwachungsleitungen auf den Setzeingang S des entsprechenden Speichers und setzt dessen Ausgang Q auf logisch "Eins". Damit ist der Vergleichslogik 6 angezeigt, dass die zugeordnete Schaltstufe zugeschaltet ist und daher nur mehr wieder weggeschaltet werden kann. Gleichzeitig gelangt der Impuls auch über das ODER-Gatter auf den Rücksetzeingang R des entsprechenden Zählers und stellt diesen auf Null zurück. Durch das Zählen der Taktimpulse und das Zurückstellen bei jedem Schaltvorgang der zugehörigen Schaltstufe ist der Zählerstand dieses Zählers ein Mass für die Zeit, die seit dem letzten Schaltvorgang, hier seit dem Zuschalten, vergangen ist.

Wird die Schaltstufe durch einen Steuerbefehl über die Umschaltlogik 8 wieder aus der Serienschaltung weggeschaltet, wird ein Impuls über die Wegschaltleitung W der Überwachungsleitungen auf den Rücksetzeingang R des Flip-Flops gegeben und der Ausgang Q auf logisch "Null" gesetzt. Damit ist der Vergleichslogik 6 angezeigt, dass die angeschlossene Schaltstufe weggeschaltet ist und nur mehr bei Gelegenheit wieder zugeschaltet werden kann. Gleichzeitig gelangt auch dieser Impuls über das "ODER" Gatter auf den Rücksetzgang R des Zählers und stellt diesen erneut auf Null zurück.

Der Zählerstand der Zähler Z1... Z6, der bei jedem Taktimpuls generell um eine Eins erhöht wird, ist also stets ein Mass für die Zeit, die bei jeder Schaltstufe seit dem letzten Schaltvorgang verstrichen ist, unabhängig davon, ob dieser Schaltvorgang ein Zu- oder Wegschalten der Stufe bedeutet hat. Andererseits zeigen die Flip-Flops F1... F6 an ihren Ausgängen Q an, welche der Schaltstufen S1... S6 gerade zu- und welche gerade weggeschaltet ist. Aus dieser Einteilung der Schaltstufen in zwei Gruppen und den Zählerstandsinformationen ermittelt die Vergleichslogik 6 durch Vergleich für die Gruppe der zugeschalteten Schaltstufen diejenige, die bereits die längste Zeit zugeschaltet ist und für die Gruppe der weggeschalteten Schaltstufen entsprechend diejenige, die bereits die längste Zeit weggeschaltet ist. Die Adressinformationen, d.h. die codierten Nummern beider Schaltstufen werden am Ausgang A3 über getrennte Zu- und Wegschaltleitungen an die Dekodierer 9 und 10 in der Ansteuereinheit 2 übermittelt.

Die anhand der Fig. 1 - 4 beschriebenen und erläuterten Ausführungsbeispiele des Schaltverstärkers und seiner Komponenten können vom Durchschnittsfachmann im Sinne der Erfindung in vielfacher Weise abgewandelt und den speziellen Erfordernissen angepasst werden. So ist es unter anderem möglich, bei dem beschriebenen Ausführungsbeispiel der Überwachungseinheit 3 gemäss Fig. 2 auf Überwachungsleitungen von den Schaltstufen S1... S6 zu der Überwachungseinheit 3 zu verzichten und die Überwachungseinheit 3 mit der Ansteuereinheit 2 zu einer gemeinsamen Einheit zusammenzufassen. Die Steuerbefehle zum Zu- bzw. Wegschalten von Schaltstufen gelangen dann parallel und gleichzeitig sowohl zu den Schaltstufen S1... S6, als auch zu den Speichern F1... F6 der Überwachungseinheit, so dass eine Rückkopplungsschleife über die Schaltstufen S1... S6 entfällt.

Weiterhin ist es auch nicht unbedingt erforderlich, alle Steuerleitungen innerhalb des Schaltverstärkers als getrennte Paare von Zu- und Wegschaltleitungen Z und W auszubilden. So können beispielsweise die Steuerbefehle für eine Schaltstufe auf einer gemeinsamen Leitung, speziell einer Lichtleitfaser, übertragen werden, wobei der Zu- oder Wegschaltbefehl jeweils als unterschiedlich codiertes Signal, in Form einer logischen "0" und "1" oder in Form positiver und negativer Impulsflanken, auftritt.

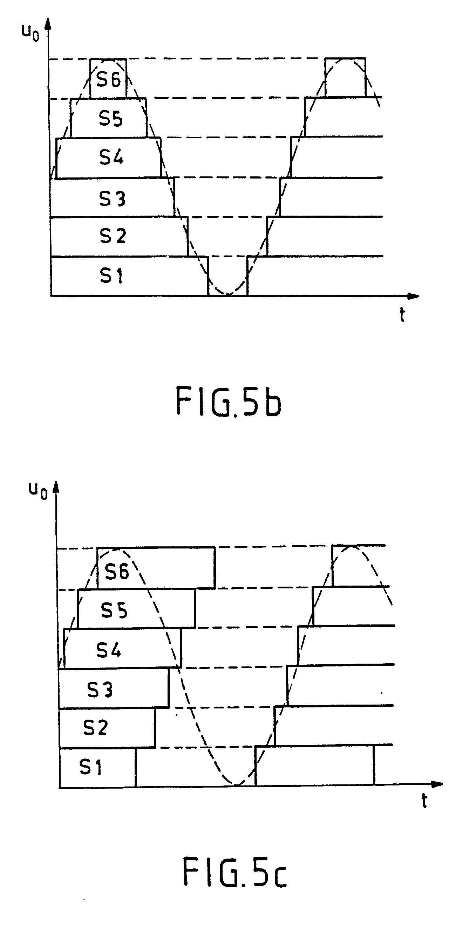

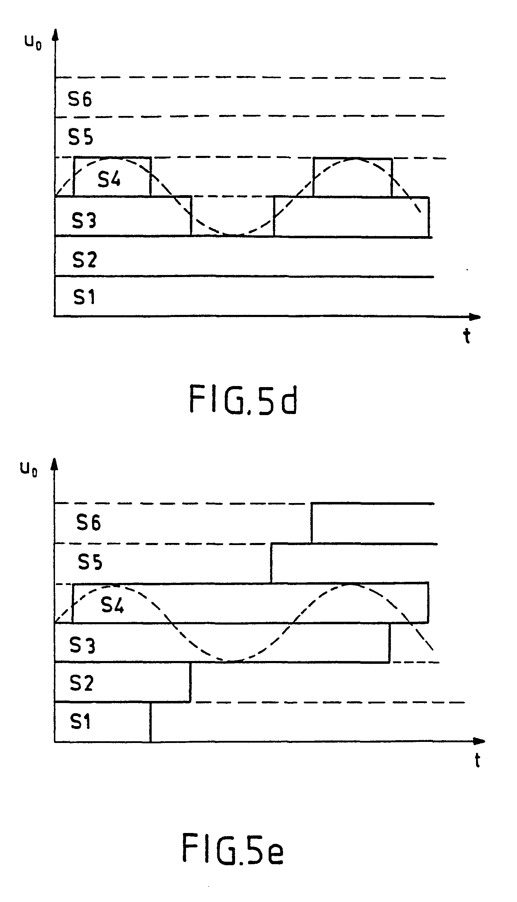

Die aus den beschriebenen Ausführungsbeispielen resultierende Zuordnung zwischen den Spannungsstufen V1... V6 des Eingangssignalbereichs ESB und den Schaltstufen S1... S6 ist in den Fig. 5a, 5c und 5e dargestellt, während die Fig. 5b und 5d eine Zuordnung nach dem Stand der Technik zum Vergleich beschreiben. Die Fig. 5a zeigt den zeitlichen Verlauf $u_i$ (t) zweier sinusförmiger Signalamplituden $u_i$, von denen die eine den gesamten Eingangssignalbereich ESB überstreicht, während die andere nur etwa den dritten Teil jener Amplitude ausmacht. Dies entspricht in der Anwendung des Verstärkers für die Modulation eines Leistungssenders entsprechend unterschiedlichen Modulationsgraden.

Der Eingangssignalbereich ESB ist in Übereinstimmung mit der Anzahl der Schaltstufen S1... S6 in die sechs Spannungsstufen V1... V6 aufgeteilt. Betrachtet man zunächst das grössere der beiden sinusförmigen Signale, so ist unmittelbar zu erkennen, dass die Amplitude $u_i$, von Null ausgehend, nacheinander die Spannungsstufen V4, V5 und V6 bis zum Maximum durchläuft und anschliessend in umgekehrter Reihenfolge V6 bis V1 nacheinander bis zum Minimum bzw. negativen Maximum passiert. In analoger Weise werden bei dem Verstärker nach dem Stand der Technik (Fig. 5b) zunächst die Schaltstufen S4, S5 und S6 zugeschaltet und anschliessend in umgekehrter Reihenfolge S6 bis S1 nacheinander weggeschaltet. Anhand der Darstellung in Fig. 5b ist sofort zu sehen, dass sich bei dieser festen Zuordnung für die einzelnen Schaltstufen S1... S6 die eingangs erwähnten ungleichmässigen Betriebsbedingungen einstellen: Während die Schaltstufen S1 und S6 überwiegend zu- bzw. weggeschaltet sind und daher sehr kurze Weg- bzw. Zuschaltphasen haben, sind bei den Stufen S4 und S4 die beiden Phasen annähernd gleich lang.

Ein vollkommen anderes Betriebsverhalten ergibt sich gemäss Fig. 5c für die variable Zuordnung zwischen Spannungsstufen V1... V6 und Schaltstufen S1... S6, wie sie bei dem erfindungsgemässen Verstärker verwendet wird und anhand der Ausführungsbeispiele ausführlich erläutert worden ist. Zwar werden auch hier, wie beim Stand der Technik, bei ansteigender Eingangssignalamplitude $u_i$ zunächst nacheinander die Schaltstufen S4, S5 und S6 zugeschaltet. Sobald jedoch die Amplitude $u_i$ abfällt und ihrem Minimalwert zustrebt, werden die wesentlichen Unterschiede zum bekannten Verstärker deutlich: Nicht die Schaltstufe S6 wird als erste wieder weggeschaltet, sondern die Schaltstufe S1, weil diese Schaltstufe zu diesem Zeitpunkt bereits die längste Zeit zugeschaltet gewesen ist. Dasselbe gilt für die Schaltstufen S2, S3,..., S6, die nacheinander weggeschaltet werden. Während also in diesem speziellen Beispiel die Reihenfolge im Zuschalten der Schaltstufen S1... S6 durch willkürliche Festlegung mit derjenigen im bekannten Verstärker übereinstimmt, ergibt sich beim Wegschalten zwangsläufig die genau entgegengesetzte Reihenfolge.

Die Summation der Ausgangsspannungen der zugeschalteten Schaltstufen mit ihren Gleichspannungsquellen zu einer Ausgangsspannungsamplitude $u_o$ führt, wie man leicht nachprüfen kann, in beiden Fällen (Fig. 5a und 5b) zu derselben Treppenspannung, die nach einem Glättungsprozess dem verstärkten Eingangssignal entspricht. Das Betriebsverhalten der Schaltstufen S1... S6 ist dabei jedoch vollkommen unterschiedlich. Im Gegensatz zu den erwähnten ungleichmässigen Betriebsbedingungen aufgrund unterschiedlich langer Schaltphasen, wie sie in Fig. 5b zum Ausdruck kommen, werden gemäss Fig. 5c die Schaltstufen S1... S6 weitgehend gleichmässig geschaltet, wobei die Schaltphasen für jede Schaltstufe annähernd gleich lang sind.

Noch deutlicher werden die Auswirkungen und Vorteile beim erfindungsgemässen Verstärker, wenn man statt der maximalen Eingangssignalamplitude ein Eingangssignal mit einer kleineren Amplitude betrachtet, wie es beispielsweise bei einem Rundfunksender aufgrund der Amplitudenverteilung wesentlich häufiger vorkommt. Ein solches Signal, das nur zwischen zwei Spannungsstufen V3 und V4 variiert, ist in Fig. 5a ebenfalls dargestellt. Nach dem Stand der Technik werden die Schaltstufen S1... S6 in der in Fig. 5d gezeigten Weise angesteuert: Die Schaltstufen S1 und S2 sind in diesem Fall fortwährend zugeschaltet und die Schaltstufen S5 und S6 entsprechend fortwährend weggeschaltet. Alle vier genannten Stufen verursachen daher keine Schaltverluste. Die gesamten Schaltbelastungen werden ausschliesslich von den beiden Schaltstufen S3 und S4 getragen, die den Spannungsstufen V3 und V4 fest zugeordnet sind.

Ganz anders dagegen ist die Ansteuerung gemäss Fig. 5e bei der variablen Zuordnung zwischen den Spannungsstufen V1... V6 und den Schaltstufen S1... S6: Alle Schaltstufen werden gleichmässig zu- bzw. weggeschaltet und die Schaltbelastungen entsprechend auf alle Schaltstufen verteilt. Ein weiterer Vorteil wird ebenfalls im Vergleich zu Fig. 5d deutlich; während dort die Schaltfrequenz der Stufen S3 und S4 gleich der Frequenz des Eingangssignals ist, wird in Fig. 5e die Schaltfrequenz auf ein Drittel dieser Signalfrequenz reduziert und auf alle Schaltstufen S1... S6 verteilt, weil die Eingangssignalamplitude ebenfalls nur etwa ein Drittel des Eingangssignalbereichs ESB ausmacht.

Diese Relation folgt dem allgemeinen Zusammenhang, dass mit abnehmender Amplitude des Eingangssignals die Schaltfrequenz der einzelnen Schaltstufen im Vergleich zur Signalfrequenz ebenfalls abnimmt.

Obgleich also die insgesamte, Anzahl der Schaltvorgänge in allen Schaltstufen zusammengenommen gegenüber dem bekannten Verstärker unverändert bleibt, werden die Schaltvorgänge in jedem Fall auf alle Schaltstufen sehr gleichmässig verteilt, was allgemein zu einer Reduktion der Schaltfrequenzen in den einzelnen Stufen führt und hinsichtlich der zu schältenden Ströme eine gleichmässigere Belastung aller Stufen ergibt.

Insbesondere ist die beschriebene Art der Ansteuerung von Vorteil, wenn in den Schaltstufen Thyristoren, besonders die bekannten Abschalt- oder Gate-turn-off (GTO)-Thyristoren, als Schaltelemente eingesetzt werden sollen. Die Thyristoren sind aufgrund ihrer Freiwerdezeit und der Wirkungen ihrer äusseren Beschaltung dahingehend in der Anwendung beschränkt, dass zwischen einem Zu- und Wegschaltvorgang eine gegenüber Leistungstransistoren vergleichsweise lange Zeitspanne liegen muss, um ein einwandfreies Funktionieren sicherzustellen. Diese Zeitspanne wird durch das erfindungsgemässe Verfahren im Mittel wesentlich verlängert, so dass sich gerade für Thyristoren ein neuer Anwendungsbereich eröffnet.

**Patentansprüche**

1. Schaltverstärker zur digitalen Leistungsverstärkung eines analogen Eingangssignals mit einem Signalwandler (1) und einer Mehrzahl von gleichartigen, in Serie liegenden Schaltstufen (S1... S6), wobei der Signalwandler (1) den Eingangssignalbereich (ESB) in eine der Anzahl der Schaltstufen (S1... S6) entsprechende Zahl von gleichen Spannungsstufen (V1... V6) unterteilt, das analoge Eingangssignal über einen Eingang (14) fortlaufend abtastet und an einem Ausgang (A1) Steuerbefehle in der Weise an die Schaltstufen (S1 ... S6) abgibt, dass bei einer Änderung der Amplitude ($u_i$) des Eingangssignals um eine Spannungsstufe (V1 ... V6) eine Schaltstufe (S1... S6) in der Serienschaltung zu- bzw. weggeschaltet wird, dadurch gekennzeichnet, dass die Ansteuerung der Schaltstufen (S1 ... S6) von dem Signalwandler (1) über eine Ansteuereinheit (2) erfolgt, welche Ansteuereinheit (2) vor jedem Schaltvorgang die Zuordnung zwischen Spannungsstufe (V1... V6) und Schaltstufe (S1... S6) nach Massgabe des jeweiligen Betriebszustandes der Schaltstufen (S1... S6) neu festlegt.

2. Schaltverstärker nach Anspruch 1, dadurch gekennzeichnet, dass den Schaltstufen (S1... S6) eine Überwachungseinheit (3) zur Überwachung des Betriebszustandes der Schaltstufen (S1... S6) zugeordnet ist und die Zuordnung zwischen Spannungsstufe (V1... V6) und Schaltstufe (S1...

S6) in der Ansteuereinheit (2) von der Überwachungseinheit (3) gesteuert wird.

3. Schaltverstärker nach Anspruch 2, dadurch gekennzeichnet, dass jede Schaltstufe (S1... S6) mit einer Zeitmesseinrichtung zur Messung der Zeit zwischen zwei aufeinanderfolgenden Schaltvorgängen und einem Speicher (F1 ... F6) zur Speicherung des jeweiligen Schaltzustandes verbunden ist und dass die Zeitmesseinrichtungen und Speicher (F1... F6) ihrerseits mit einer Vergleichslogik (6) verbunden sind, welche Vergleichslogik (6) die Werte der Zeitmesseinrichtungen vergleicht und für den nächsten Schaltvorgang diejenige Schaltstufe auswählt, die nach ihrem Schaltzustand geeignet ist und ihren Schaltzustand die längste Zeit nicht geändert hat.

4. Schaltverstärker nach Anspruch 3, dadurch gekennzeichnet, dass der Signalwandler (1) und die Überwachungseinheit (3) mit einem Taktgeber (5) verbunden sind, und die Zeitmesseinrichtungen als digitale Zähler (Z1... Z6) ausgebildet sind, die über Takteingänge (T) von dem Taktgeber (5) Zählimpulse erhalten.

5. Schaltverstärker nach einem der Ansprüche 4 und 5, dadurch gekennzeichnet, dass die Speicher (F1... F6) als bistabile Kippschaltungen (Flip-Flop) ausgebildet sind und synchron mit den Steuerbefehlen aus der Ansteuereinheit (2) gesetzt oder gelöscht werden.

6. Schaltverstärker nach einem der Ansprüche 1 bis 5, dadurch gekennzeichnet, dass jede Schaltstufe (S1... S6) eine Gleichspannungsquelle (U1... U6) und ein Schaltelement (SE1... SE6) aufweist und die Gleichspannungsquelle (U1... U6) und das Schaltelement (SE1... SE6) in der Weise angeordnet sind, dass die Gleichspannungsquelle (U1... U6) in der Serienschaltung der Schaltstufen (S1... S6) wahlweise überbrückt oder mit den Gleichspannungsquellen anderer Schaltstufen in Serie geschaltet werden kann.

7. Schaltverstärker nach Anspruch 6, dadurch gekennzeichnet, dass die Schaltstufen (S1... S6) als Schaltelemente (SE1... SE6) Thyristoren enthalten.

8. Schaltverstärker nach einem der Ansprüche 1 bis 7, dadurch gekennzeichnet, dass der Signalwandler (1) einen Analog-Digital-Wandler (11) und einen nachgeschalteten Amplitudenwertspeicher (12) enthält, in welchen Amplitudenwertspeicher (12) der jeweilige digitale Amplitudenwert eingespeichert wird, und dass eine Vergleichslogik (13) den Amplitudenwert aus dem Amplitudenwertspeicher (12) mit dem jeweils nachfolgenden, digitalen Amplitudenwert vergleicht und an seinem Ausgang (A1) entsprechend dem Ergebnis des Vergleichs einen Zuschaltbefehl oder einen Wegschaltbefehl an die Ansteuereinheit (2) weitergibt.

**Claims**

1. Switching amplifier for the digital power amplification of an analog input signal comprising a signal convertor (1) and a plurality of similar series-connected switching stages (S1. .. S6), in which arrangement the signal convertor (1) subdivides the input signal range (ESB) into a number of equal voltage steps (V1 ... V6) corresponding to the number of switching stages (S1 ... S6), continuously samples the analog input signal via an input (14) and at an output (A1) forwards control commands to the switching stages (S1 ... S6) in such a manner that, if the amplitude ($u_i$) of the input signal changes by one voltage step (V1 ... V6), a switching stage (S1 ... S6) in the series-circuit is connected or disconnected, characterized in that the switching stages (S1 ... S6) are driven by the signal convertor (1) via a drive unit (2), which drive unit (2) redetermines before each switching process the association between voltage step (V1 ... V6) and switching stage (S1 ... S6) in accordance with the respective operating condition of the switching stages (S1 ... S6).

2. Switching amplifier according to Claim 1, characterized in that the switching stages (S1 ... S6) are associated with a monitoring unit (3) for monitoring the operating condition of the switching stages (S1 ... S6) and the association between voltage step (V1 ... V6) and switching stage (S1 ... S6) in the drive unit (2) is controlled by the monitoring unit (3).

3. Switching amplifier according to Claim 2, characterized in that each switching stage (S1 ... S6) is connected to a time measuring device for measuring the time between two successive switching processes and to a memory (F1... F6) for storing the respective switching state and that the time measuring devices and memories (F1... F6), in turn, are connected to a comparing logic (6) which comparing logic (6) compares the values of the time measuring devices and selects for the next switching process the switching stage which is suitable in accordance with its switching state and which has not changed its switching state for the longest time.

4. Switching amplifier according to Claim 3, characterized in that the signal convertor (1) and the monitoring unit (3) are connected to a clock generator (5) and the time measuring devices are constructed as digital counters (Z1 ... Z6) which obtain counting pulses from the clock generator (5) via clock inputs (T).

5. Switching amplifier according to one of Claims 4 and 5, characterized in that the memories (F1 ... F6) are constructed as bi-stable flip-flop circuits and are set or cleared in synchronism with the control commands from the drive unit (2).

6. Switching amplifier according to one of Claims 1 to 5, characterized in that each switching stage (S1 ... S6) is provided with a direct-voltage source (U1 ... U6) and a switching element (SE1 ... SE6) and the direct-voltage source (U1 ... U6) and the switching element (SE1. .. SE6) are arranged in such a manner that the direct-voltage source (U1 ... U6) in the series circuit of the switching stages (S1 ... S6) can be optionally bridged or connected in series with the direct-voltage sources of other switching stages.

7. Switching amplifier according to Claim 6, characterized in that the switching stages (S1... S6) contain thyristors as switching elements (SE1. .. SE6).

8. Switching amplifier according to one of Claims 1 to 7, characterized in that the signal convertor (1) contains an analog/digital convertor (11) and a subsequent amplitude-value memory (12) into which amplitude-value memory (12) the respective digital amplitude value is stored and that a comparing logic (13) compares the amplitude value from the amplitude-value memory (12) with the digital amplitude value following in each case and passes at its output (A1) a connection command or a disconnection command to the drive unit (2) in accordance with the result of the comparison.

**Revendications**

1. Amplificateur de commutation pour l'amplification de puissance numérique d'un signal d'entrée analogique, comportant un convertisseur de signaux (1) et plusieurs étages de commutation semblables montés en série (S1. .. S6), dans lequel le convertisseur de signaux (1) divise le domaine de signal d'entrée (ESB) en un nombre d'échelons de tension égaux (V1 ... V6) correspondant au nombre des étages de commutation (S1 ... S6), le signal d'entrée analogique est analysé de manière continue par l'intermédiaire d'une entrée (14) et fournit sur une sortie (A1), des ordres de commande pour les étages de commutation (S1 ... S6), d'une manière telle que dans le cas d'une modification de l'amplitude ($u_i$) du signal d'entrée d'un échelon de tension (V1 ... V6), un étage de commutation (S1 ... S6) est inclus dans le montage en série, ou en est exclu, caractérisé en ce que la commande des étages de commutation (S1 ... S6) est assurée par le convertisseur de signaux (1), par l'intermédiaire d'une unité de commande (2), qui détermine, avant chaque opération de commutation, une nouvelle association entre échelons de tension (V1 ... V6) et étages de commutation (S1 ... S6) en fonction de l'état de fonctionnement respectif des étages de commutation (S1 ... S6).

2. Amplificateur de commutation suivant la revendication 1, caractérisé en ce qu'une unité de surveillance (3) destinée à surveiller l'état de fonctionnement des étages de commutation (S1. .. S6) est associée aux étages de commutation (S1 ... S6), l'association entre échelons de tension (V1 ... V6) et étages de commutation (S1 ... S6) dans l'unité de commande (2) étant régie par l'unité de surveillance (3).

3. Amplificateur de commutation suivant la revendication 2, caractérisé en ce que chaque etage de commutation (S1 ... S6) est connecté à un dispositif de mesure du temps pour mesurer le temps qui s'écoule entre deux opérations de commutation successives et à une mémoire (F1 ... F6) pour stocker l'état de commutation du moment et que les dispositifs de mesure du temps ainsi que les mémoires (S1 ... S6) sont connectés pour leur part à un circuit logique de comparaison (6) qui compare les valeurs des dispositifs de mesure du temps et sélectionne pour l'opération de commutation suivante, l'étage de commutation qui convient d'après son état de commutation et dont l'état de commutation n'a plus été modifié depuis le plus long laps de temps.

4. Amplificateur de commutation suivant la revendication 3, caractérisé en ce que le convertisseur de signaux (1) et l'unité de surveillance (3) sont connectés à un générateur de signaux d'horloge (5) et les dispositifs de mesure du temps ont la forme de compteurs numériques (Z1 ... Z6) qui reçoivent des impulsions de comptage du générateur de signaux d'horloge (5) par l'intermédiaire d'entrées d'horloge (T).

5. Amplificateur de commutation suivant la revendication 4 ou 5, caractérisé en ce que les mémoires (F1 ... F6) ont la forme de bascules bistables (flip-flop) qui sont positionnées ou repositionnées en synchronisme avec les ordres de commande provenant de l'unité de commande (2).

6. Amplificateur de commutation suivant l'une quelconque des revendications 1 à 5, caractérisé en ce que chaque étage de commutation (S1 ... S6) comporte une source de tension continue (U1. .. U6) et un élément de commutation (SE1 ... SE6) et la source de tension continue (U1 ... U6), ainsi que l'élément de commutation (SE1 ... SE6) sont disposés d'une manière telle que la source de tension continue (U1 ... U6) puisse sélectivement être pontée dans le montage en série des étages de commutation (S1 ... S6) ou être connectée en série avec les sources de tension continue d'autres étages de commutation.

7. Amplificateur de commutation suivant la revendication 6, caractérisé en ce que les étages de conunutation (S1 ... S6) contiennent des thyristors à titre d'éléments de commutation (SE1. .. SE6).

8. Amplificateur de commutation suivant l'une quelconque des revendications 1 à 7, caractérisé en ce que le convertisseur de signaux (1) comprend un convertisseur analogique-numérique (11) suivi d'une mémoire de valeurs d'amplitude (12), dans laquelle la valeur d'amplitude numérique du moment est stockée, et qu'un circuit logique de comparaison (13) compare la valeur d'amplitude provenant de la mémoire de valeurs d'amplitude (12) chaque fois avec la valeur d'amplitude numérique suivante et fournit sur sa sortie (A1), en fonction du résultat de la comparaison, un ordre d'inclusion dans le montage ou d'exclusion du montage à l'unité de commande (2).

FIG.1

FIG.2

FIG.3

T1

A

D

11

13

12

1

Z

A1

W

14

## FIG.4

$u_i$

ESB

V6
V5
V4
V3
V2
V1

t

## FIG.5a

FIG.5b

FIG.5c

FIG.5d

FIG.5e